# EUROPEAN PATENT SPECIFICATION

(11) **EP 0 591 317 B1**
(45) Date of publication and mention of the grant of the patent: **12.11.1997**
(21) Application number: 92913053.2
(22) Date of filing: 26.05.1992
(51) Int. Cl.: B32B 5/16

(54) **A FLEXIBLE, TRANSPARENT FILM FOR ELECTROSTATIC SHIELDING**
FLEXIBLER, TRANSPARENTE FILM FUER ELEKTROMAGNETISCHE ABSCHIRUNG
FILM FLEXIBLE ET TRANSPARENT POUR BLINDAGE ELECTROSTATIQUE

(30) Priority: 28.06.1991 US 722923; 28.06.1991 US 722956
(43) Date of publication of application: 13.04.1994
(73) Proprietor: MINNESOTA MINING AND MANUFACTURING COMPANY, St. Paul, Minnesota 55133-3427 (US)
(72) Inventor: WISTE, Orville, M., Saint Paul, MI 55133-3427 (US); COLLISON, Santosh, Saint Paul, MI 55133-3427 (US); KUMAR, Vijay, A., Saint Paul, MI 55133-3427 (US)
(74) Representative: Molyneaux, Martyn William
(86) International application number: US9204422
(87) International publication number: WO9300221

(56) References cited:
- EP-A- 0 219 315
- EP-A- 0 422 928
- DE-A- 3 539 961
- US-A- 4 746 574
- US-A- 4 983 452

## Description

### Background of the Invention

### 1. Field of the Invention

The present invention generally relates to packaging materials for products which are sensitive to static electric fields and discharge, and more particularly to a flexible, transparent film (and a method of making the film) which shields against electrostatic fields, and further resists triboelectric generation of static charges and provides for the rapid dissipation of such charges.

### 2. Description of the Prior Art

Electrostatic discharge, as well as the mere presence of a static electric field, can be extremely detrimental to sensitive electronic parts. This is particularly true of modern semiconductors and integrated circuits which may be degraded or destroyed by the buildup of static electricity in the workplace. Especially sensitive components can be severely affected by an electrical potential as small as 50 volts, yet the simple act of walking has been shown to triboelectrically generate a potential of 30,000 volts or more.

One of the most common methods of protecting electronic components is to store, ship and handle them using pouches, bags, tote boxes or other packaging constructed of materials which provide shielding against electrostatic fields and other electromagnetic influences. These materials may additionally provide for the rapid dissipation of electrostatic charges which are applied to the package, and/or include a coating which prevents or minimizes triboelectric charging along the surface of the package. The present invention is directed to a film which may be fashioned into packaging providing such protection, and to a method of making such a film.

The most basic function provided by these types of films is protection from static electric fields. This is typically achieved by forming a conductive layer on the film or dispersing conductive materials therein, which effectively creates a Faraday cage. An example of a rather complicated process for creating a shielding film is disclosed in U.S. Patent No. 4,645,566 issued to Kato et al. A thermoplastic, synthetic pulp is mixed with thermoplastic, composite fibers and conductive fibers, resulting in a paper-type stock. This stock may be formed into a web, and when it is heated and dried at appropriate temperatures, the pulp melts, leaving a film which has a network of conductive fibers dispersed therein. Other processes using a pulp of polymeric and conductive components are discussed in Japanese Patent Application Kokai Nos. 60-210667, 60-257234 and 62-42499.

The use of a web carrier in creating a conductive intermediate layer is common. In U.S. Patent Nos. 4,939,027 and 4,983,452, both issued to Daimon et al., a moldable static-shielding sheet is formed by first obtaining a web of nonwoven fabric comprising conductive fibers and thermoplastic fibers. The web may alternatively be formed by irregularly twining a conductive fiber with a hot-melt adhesive fiber. The web is placed between two thermoplastic films and heated. This bonds the films to the web, and further causes the thermoplastic fibers in the web to melt and combine with the films, leaving an imbedded layer of conductive fibers. Other techniques utilizing a web or fabric are shown in Japanese Patent Application Kokai Nos. 60-34099, 60,143699, 62-47200, 62-122300, 62-275727,and 62-276297.

In addition to providing electrostatic shielding, these films may be treated to provide for the rapid dissipation of static charges, and to further minimize the triboelectric generation or such charges. In accordance with the American National Standards Institute EIA standard 541 ("Packaging Material Standards for ESD Sensitive Items," published June 1988) the first of these qualities is referred to as static-dissipative, and the latter is referred to as antistatic. For example, U.S. Patent No. 4,623,594 issued to A. Keough teaches the use of an electron-beam curable resin composition which may be applied to a substrate, and which causes the antistatic properties to migrate through the substrate upon curing.

One product which combines the qualities of electrostatic shielding, static-dissipation and triboelectric charge resistance is described in U.S. Patent Nos. 4,154,344 and 4,156,751, both issued to Yenni et al. Those patents describe a sheeting material which is formed by first applying a conductive material, such as nickel, to one surface of a biaxially oriented polymer substrate, namely, polyester. The exposed nickel surface is then coated by a solvent process with a protective layer. A film of heat-sealable material (polyethylene) is extruded onto the opposite surface of the polyester film. The extruded polyethylene may include antistatic material (such as quaternary ammonium compounds), or be further coated with such antistatic agents. Other conductive materials, such as carbon-loaded plastics, may be substituted for the metallic coating.

A similar product and process is described in U.S. Patent No. 4,756,414 issued to C. Mott, except that the conductive layer is provided between the heat-sealable plastic and the second plastic layer. The conductive layer is applied by either vacuum deposition or sputtering techniques. The two plastic layers may be joined using a thermosetting adhesive. See also Japanese Patent Kokoku No. 38398/89. In U.S. Patent No. 4,875,581 issued to Ray et al., a dielectric material is interposed between the two plastic layers and, in addition to a conductive layer, the outer elastomeric layer of the film includes additives which make it static-dissipative. Even more complicated processes and resulting structures are known, such as the film discussed in U.S. Patent No. 4,906,494 issued to Babinec et al., which utilizes a two-ply layer having a polyolefin and a copolymer of ethylene-acrylic acid and ethylene-vinyl acetate. In Babinec, the layers are joined using an adhesive or hot roll lamination.

Another laminated film is disclosed in U.S. Patent No. 3,888,711 issued to W. Breitner. Although that film is primarily intended for use as a heated window or alarm glass, Breitner notes that it may also be used for shielding against electromagnetic interference. The lamination process used requires a knit of thermoplastic and conductive filaments which is applied to a sheet of thermoplastic material. The thermoplastic filaments are preferably constructed of the same materials as the thermoplastic sheet; the thermoplastic filaments should at least be fusible with the sheet. When the sheet is fed through hot rolls, the thermoplastic filaments fuse with the sheet, leaving a network of conductive filaments forming a plurality of interconnected conductive paths. A cover sheet may be laid on top of the network before hot rolling. Another lamination technique (using conductive strands rather than a web) is depicted in Japanese Patent Application Kokai No. 60-81900.

Each of the foregoing techniques has its disadvantages. First and foremost of these is the poor transmission of visible light ("transmissivity") through these films and packaging formed therefrom, whether they rely on metal coatings, carbon-loading or filament networks. Previously, increasing transmissivity meant sacrificing static-shielding ability. The best transmissivity claimed by any of the foregoing processes is 60%, although this has proven very difficult to achieve at production levels. Furthermore, while this level of transmissivity allows a visual inspection of the general condition of items contained in the packaging, it does not provide adequate legibility, i.e., the ability to read printed matter on the item in the packaging, particularly if the printing is not flush against the interior surface of the film.

With respect to films formed using webs, fabrics or pulp, those processes are generally more complicated and, hence, more expensive; they also often produce hazardous metal dust. The resulting films typically have even less transmissivity than metal coatings, but such coating processes also add significant expense. Pulp-type films are conductive through their thickness, and so require additional process steps to insulate their surfaces. As noted by Kato et al., films resulting from these processes further have inferior physical and chemical bonding resulting in low tensile, tear and surface strength.

A thin, conductive filamentary network would overcome many of these problems but it has been difficult in the past to apply such a network without the use of webs or pulp. Breitner notes that applying metal strips is labor intensive, but his process still requires a special prefabricated knit (or special machinery to directly apply filaments to the film). Breitner further notes the difficulties in using very thin conductive filaments, which would be preferable since this would enhance transmissivity through the network. Another problem with static-shielding films using filaments is that the network must be relatively dense, which inhibits transmissivity. For example, Daimon et al. ('027) teaches that the network must have minimum density of 15 g/m². Finally, interposing a conductive network between two polymeric layers often results in wrinkles and/or voids at the interface where the filaments lay. This affects transmissivity and legibility, and may also increase the likelihood of peeling.

Several of the above limitations have been overcome by the process described in U.S. Patent Application Serial No. 07/270,532 (D. Koskenmaki), assigned to Minnesota Mining and Manufacturing Co. (3M), assignee of the present invention. In that process, which probably represents the closest prior art, molten strands of conductive material are squirted directly onto a polymeric substrate, which may then be further laminated. Nevertheless, the equipment necessary to produce molten filaments is relatively expensive, and presents clear hazards. Also, since the exemplary laminated films of Koskenmaki create an interface at the filamentary network, they are more likely to have wrinkles and/or voids, and more prone to peeling at the interface. Therefore, it would be desirable and advantageous to manufacture a static-shielding film by applying a very sparse network of thin conductive filaments to a polymeric sheet to achieve improved transmissivity and legibility, the filaments further being suspended in a polymeric layer in such a manner that there is no discernable interface surrounding the filaments even though they form an essentially two-dimensional conductive network. The filaments should further not be applied in a molten state.

### Summary of the Invention

The foregoing objective is achieved in a film comprising a first layer of a carrier material which is electrically insulative, flexible, transparent, and dimensionally stable, and a second layer of a polymeric material bonded to the first layer, the polymeric material being electrically insulative, flexible, transparent, and thermoplastic, there being a plurality of conductive slivers embedded in the second layer forming an essentially two-dimensional, conductive network. The overall thickness of the film is relatively thin, e.g., about 100 µm, and the sliver may be present in an amount as little as 2 g/m², resulting in a staticshielding film which passes at least 70% of visible light, and upwards of 85% of visible light. The slivers advantageously have a melting temperature above the melting temperature of the polymeric material, and the polymeric material further has a melting temperature which is lower than the melting temperature of the carrier material.

The film is constructed by a process in which the slivers are applied to a sheet material having a dimensionally stable layer and a thermoplastic layer, the thermoplastic layer having a melting temperature which is lower than the melting temperature of the dimensionally stable layer. The slivers are applied to the surface of the thermoplastic layer. A thermoplastic material which is miscible with the thermoplastic layer is then extruded in sheet form, laid over the slivers while the material is still molten, and hot-rolled, causing the extruded sheet and the thermoplastic layer to combine into a single, homogenous layer. The slivers may be applied to the sheet material using a mechanical deflector, a magnetic attractor, an electrostatic attractor, or blown onto the surface of the thermoplastic layer when the layer is in a molten state.

### Brief Description of the Drawings

The novel features and scope of the invention are set forth in the appended claims. The invention itself, however, will best be understood by reference to the accompanying drawings, wherein:
Figures 1A and 1B are side elevational views of the process equipment used to manufacture the static-shielding film in accordance with alternative embodiments of the present invention;
Figure 2 is an enlarged side elevational view showing the lamination of the sheet material having slivers thereon with the extruded cover sheet;
Figure 3 is a cross-sectional view of the static-shielding film resulting from the process of the present invention; and
Figure 4 is a perspective view of a pouch made from the static-shielding film in accordance with the present invention.

### Description of the Preferred Embodiment

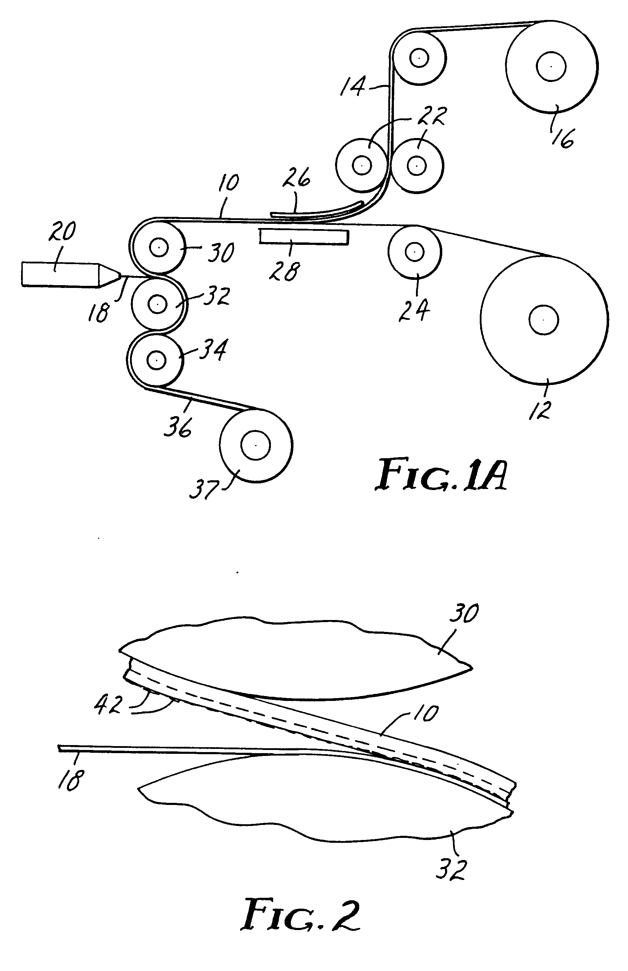

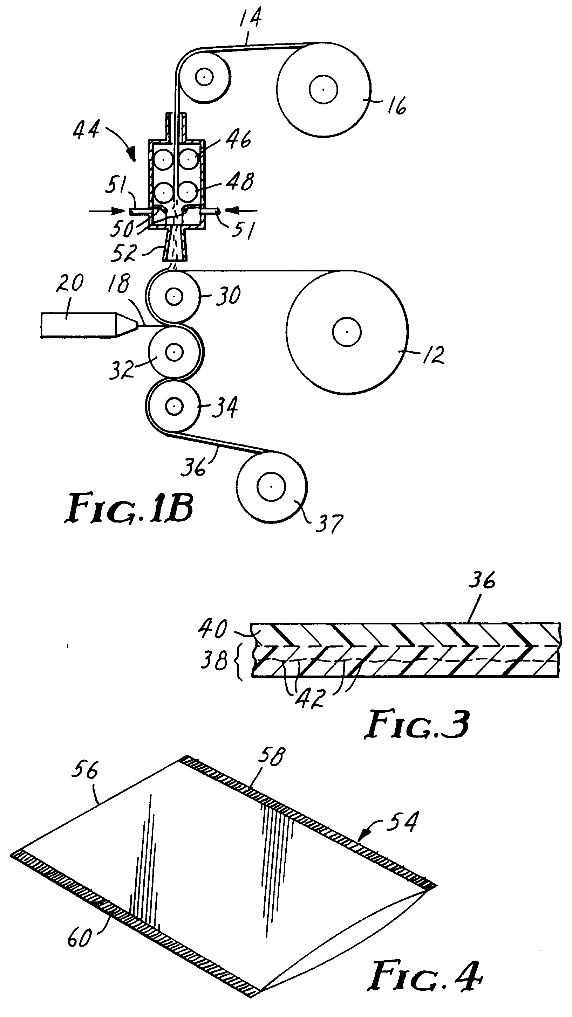

With reference now to the figures, and in particular with reference to Figures 1A and 1B, two methods of manufacturing a static-shielding film in accordance with the present invention are depicted. The three basic material components of the film are a sheet material **10** wound on a supply roll **12**, a plurality of conductive strands gathered together in a tow **14**, which may be provided on another supply roll **16**, and a cover sheet **18** which is extruded from a die **20**.

The sheet material **10** comprises a first layer formed of any electrically insulative and flexible carrier material, preferably polymeric, and a second layer formed of a second polymeric material which is electrically insulative, flexible, and thermoplastic. The melting temperature of the second polymeric material should be lower than that of the first polymeric (carrier) material, and both layers should be essentially transparent. In this regard, the term "transparent" means passing at least 70% of visible light. Appropriate polymers for the first polymeric material include, e.g., polyester, polypropylene or nylon. The first polymeric material has preferably been made both biaxially oriented and dimensionally stable, such as by stretching. The second polymeric material may be selected from the exemplary group consisting of low-density polyethylene, linear low-density polyethylene, high density polyethylene, ethylene methyl acrylate, ethylene vinyl acetate, or ethylene ethylacrylate. Sheet material **10** is advantageously very thin, in the range of 30 - 80 µm. In the preferred embodiment, sheet material **10** is a polymeric film known as SCOTCHPAR obtained from 3M, and comprises a first layer of polyethylene terephthalate (PET) and a second layer of polyethylene, the PET layer being about 23 µm thick, and the polyethylene layer being about 20 µm thick, yielding a total thickness of about 43 µm. The width of sheet material **10** may vary considerably, depending on the intended use of the film, e.g., a small pouch or a large bag. For example, the width may be in the range of 5 cm to several meters.

The tow **14** may comprise a plurality of very long conductive strands, or shorter slivers which are intertwined to form a rope-like tow. The strands or slivers should be very thin, i.e., a diameter no greater than about 12 µm. The strands or slivers may be formed of various metals and alloys, including stainless steel, silver or copper, or may be composite slivers formed of an inorganic filament having a conductive coating thereon. In the preferred embodiment, several identical tows are used which may be obtained from Bekaert Steel Wire Corp. of Marietta, Georgia, or Memcor Engineered Materials of Deland, Florida. Each of the tows comprise a plurality of slivers having an average length, depending upon the particular tow, of about 50 mm, 100 mm or 200 mm, the slivers being staggered and intertwined to form a cohesive rope of tow having a diameter in the range of 8 - 15 mm. These tows have adequate tensile strength to maintain their form if not handled too roughly, i.e., they may be conveyed reasonable distances without tearing or undue stretching. For fabrication of a film having a width of about 30 cm, four such tows are used.

The material for cover sheet **18** is a thermoplastic polymer which may be extruded in sheet form, and may be any of the materials listed above for the second layer of sheet **10**. The material for extruded sheet **18** is preferably the same as the second polymeric material used in sheet **10**, and should at least be miscible with the second polymeric material, as explained further below. The preferred material for cover sheet **18** is low density polyethylene, and is preferably applied in a thickness in the approximate range of 20 - 80 µm.

With further reference to Figure 1A, it can be seen that sliver tow **14** is fed through nip rolls **22** lying above sheet material **10**. The nip rolls preferably have a diameter of about 2.5 cm and are placed about 2.5 cm above sheet **10**. The nip line is perpendicular to the direction of travel of sheet **10**. Sliver tow **14** is fed through nip rolls **22** at a very slow rate with respect to the rate of movement of sheet **10**. For example, in order to apply 3 grams of slivers per square meter, using a sliver tow weighing about 0.67 grams per foot, onto a sheet **10** that is one meter wide, the nip rate should be about 1/70th of the rate of travel of sheet **10**.

Although the slivers may be applied in a regular pattern (including a grid pattern using a second nip roll to apply a second layer of perpendicular slivers), it is preferable to apply them in a random distribution. In the process embodiment of Figure 1A, it is necessary to use a sliver tow in which the individual slivers are at least 5 cm long and up to 20 cm in length, as opposed to the embodiment of Figure 1B in which the slivers or strands should be no longer than about 5 cm. It is also preferable to heat sheet **10** sufficiently to cause the second layer thereof to become tacky (e.g., by using a hot roll **24** which melts the second layer), and thereby improve the adhesion of the slivers to its surface, but this is not necessary. Other means can be used to make the surface of the second layer tacky, such as applying an adhesive, but this may lead to peeling problems. Alternatively, the slivers may become attached to sheet **10** by mechanical means such as a pinch roll or a deflector **26** which forces the slivers into contact with sheet **10**. As a further alternative, means may be provided to electromagnetically attract the slivers to sheet **10**, such as magnetic or electrostatically charged plate **28** underlying sheet **10**. This technique, of course, requires that the slivers be constructed of a magnetic or paramagnetic material.

When the slivers are applied, they form an essentially two-dimensional network, although the slivers do overlap slightly to impart conductivity throughout the network. After the slivers have been deposited on sheet **10**, the sheet is fed through a group of three cylinders **30**, **32** and **34**. If sheet **10** has not been previously heated (as by hot roll **24**), then cylinder **30** should be sufficiently hot to cause the second layer of sheet **10** to melt; it should not, however, be so hot as to cause the first layer of sheet **10** to melt. For the previous exemplary materials of PET and polyethylene, the temperature of hot roll **24** (or cylinder **30**) should be in the approximate range of 120 - 150 °C. Extruded cover sheet **18** then bonds easily to the second layer of sheet **10** as they are pressed between cylinders **30** and **32** (see Figure 2). Cylinders **32** and **34** are preferably chilled to stabilize the resulting film **36**. Film **36** may be drawn onto a take-up roll **37**.

Referring now to Figure 3, since the material forming cover sheet **18** is miscible with, and preferably the same as, the second polymeric material of the second layer of sheet **10**, the two materials blend together to form a single, homogenous layer **38**. This thermoplastic layer **38** is still strongly bound to the first layer **40** of sheet **10**. An important feature of the present invention is the manner in which the slivers **42** are suspended or embedded in the homogenous layer **38**. By applying slivers **42** to a material which is miscible with the material of cover sheet **18**, the slivers may be suspended in the resulting single layer without the creation of a discernable interface surrounding the sliver network. This minimizes wrinkles and voids in film **36**, and increases the film's integrity. Avoidance of another interface also increases transmissivity.

The only difference between the processes of Figures 1A and 1B is the manner in which slivers **42** are applied to sheet **10**. In Figure 1B, slivers **42** are pulled away from tow **14** and blown onto sheet **10** by a feeder-separator **44**. This apparatus uses a pair of counterrotating rolls **46** which feed tow **14** through the rolls at a very precise feed rate. A pair of counterrotating accelerator rolls **48**, moving at a much faster rate compared to feed rolls **46**, pull or pinch off slivers from the tow, which are then blown onto sheet **10** by a venturi-type blower **50** having side walls **52**, such as the TRANSVECTOR blower available from Vortec Corp. of Cincinnati, Ohio. Blower **50** is provided with two air hoses **51**.

In the preferred embodiment of Figure 1B, one of the feed rolls **46** is constructed of stainless steel and the other is constructed of rubber; one of the accelerator rolls **48** is also stainless steel and the other is steel with a phenolic coating. Plasma-coated rolls having a very fine knurled surface (but with a hardness of about 80 R_{c}) may have a longer lifer. Air springs may be used to forcibly urge the roll pairs together, providing an optimum nip force in the range of 20 - 90 newtons, for both feed rolls **46** and the accelerator rolls **48**. The accelerator rolls preferably move at a rate that is around 350 times as fast as the feed rolls. For example, when using slivers having a diameter of about 8 µm, feed rolls **46** may move at a linear feed rate of about 5 cm/minute while accelerator rolls **48** move at a rate of about 1,750 cm/minute. The laminar air flow provided by venturi blower **50** is in the range of 6 - 30 meters/minute. The air flow could be increased, say up to 150 m/min., if a vacuum screen (not shown) were used to convey the slivers to sheet **10**.

Several variations of the above-techniques may be used. For example, the cylinder **30**, which may be heated, may also be magnetized in order to further attract slivers **42** and hold them on the second layer of sheet **10**. Also, the slivers may be deposited directly onto the extruded sheet **18** rather than on sheet **10**. In any event, use of the foregoing techniques for applying a thin sliver network has tremendous cost advantages over other methods, such as metallizing (vapor-coating) the films.

The film **36** resulting from this process provides not only static-shielding, but also shielding against electromagnetic interference (EMI). In order to provide shielding against strong EMI signals, however, it is necessary to provide a more dense sliver network, although the amounts necessary are still much less than that required by prior art techniques. For example, as previously noted, Daimon et al. ('027) teaches that the network must have minimum density of 15 g/m² to provide EMI shielding. A film created in accordance with the present invention requires less than 15 g/m² of slivers to provide equivalent shielding, and preferably has a density of about 10 g/m². If EMI is not a concern, but protection is only required against static electrical fields, then a density of 2 g/m² or less of slivers has proven adequate.

Film **36** can be further modified by adding antistatic/static-dissipative agents to the polymeric compounds forming sheets **10** and **18**, or by coating (using conventional techniques) the outer surfaces of film **36** with such agents. Such agents are well known and include, e.g., quaternary ammonium compounds. The preferred antistatic compound is one sold by 3M under the brand name FC170C (an octoperfluoro polyether sulfonamide), and is volume-loaded into the film in an amount in the range of 0.1% - 0.4% by weight. Whether the antistat is loaded or coated, transmissivity of film **36** is still at least 70%, and tests have shown that films made in accordance with the foregoing processes have transmissivity levels as high as 85%. Furthermore, film **36** can protect not only electronic components, but also any materials or instruments which may be sensitive to electric fields/discharge, including chemicals and pharmaceuticals. Film **36** may be formed into a variety of packages, such as the pouch **54** shown in Figure 4. Pouch **54** is formed by longitudinally folding film **36**, forming a side **56**, and simultaneously heat sealing the film along two lines **58** and **60** transverse to the length of film **36** and cutting film **36** at sides **58** and **60**. In this regard, one of the two polymeric materials used in sheet **10** should be heat-sealable (e.g., polyethylene). Those skilled in the art will appreciate the many other uses for film **36**.

Although the invention has been described with reference to specific embodiments, this description is not meant to be construed in a limiting sense. Various modifications of the disclosed embodiment, as well as alternative embodiments of the invention, will become apparent to persons skilled in the art upon reference to the description of the invention. For example, there are several alternative methods for applying the slivers from tow **14** to sheet **10** which are not discussed herein. Also, the first layer of sheet material **10** may comprise a carrier which is releasable from the polymeric material forming the second layer thereof. Finally, the resulting film **36** has other uses besides electrostatic shielding, such as a susceptor for microwave ovens.

## Claims

1. A film for providing static shielding, comprising:
a first layer of a carrier material which is electrically insulative, flexible, and transparent;
a second layer of a polymeric material which is electrically insulative, flexible, transparent, and thermoplastic, said first layer being bonded to said second layer; and
a plurality of conductive slivers suspended in said second layer, forming an essentially two-dimensional, conductive network, said slivers having a melting temperature above the melting temperature of said polymeric material.

2. The film of Claim 1 wherein said carrier material is polymeric and has a melting temperature greater than the melting temperature of said polymeric material.

3. The film of Claim 1 having a total thickness no greater than about 100 µm, and passing at least 70% of visible light.

4. The film of Claim 1 wherein said slivers have an average diameter of about 8µm or less and are formed of a magnetic or paramagnetic material.

5. The film of Claim 1 wherein said polymeric material is selected from the group consisting of low-density polyethylene, linear low-density polyethylene, high density polyethylene, ethylene methyl acrylate, ethylene vinyl acetate, or ethylene ethylacrylate.

6. The film of Claim 1 wherein said slivers are present in an amount less than 15 g/m².

7. The film of Claim 2 wherein said polymeric carrier material is biaxially oriented and dimensionally stable.

8. The film of Claim 7 wherein said polymeric carrier material is selected from the group consisting of polyester, polypropylene or nylon.

9. A film for providing static shielding, comprising:
a first layer of a first polymeric material which is electrically insulative, flexible, dimensionally stable and transparent;
a second layer of a second polymeric material which is electrically insulative, flexible, transparent, and thermoplastic, and has a melting temperature which is higher than the melting temperature of said first polymeric material, said first layer being bonded to said second layer; and
a plurality of conductive slivers suspended in said second layer, forming an essentially two-dimensional, conductive network, said slivers further being present in an amount not greater than about 2 g/m², and the film passing at least 70% of visible light.

10. The film of Claim 9 wherein said slivers have a melting temperature above the melting temperature of said second polymeric material.

## Patentansprüche

1. Folie zur Gewährung elektrostatischer Abschirmung, umfassend:
eine erste Lage eines Trägermaterials, das elektrisch isolierend, flexibel und transparent ist;
eine zweite Lage eines polymeren Meterials, das elektrisch isolierend, flexibel, transparent und thermoplastisch ist, wobei die erste Lage mit der zweiten Lage verklebt ist; sowie
eine Vielzahl in der zweiten Lage suspendierter leitfähiger Faserbändchen, die ein weitgehend zweidimensionales, leitfähiges Netzwerk bilden, wobei die Faserbändchen eine Schmelztemperatur oberhalb der Schmelztemperatur des polymeren Materials besitzen.

2. Folie nach Anspruch 2, bei der das Trägermaterial polymer ist und eine Schmelztemperatur hat, die größer ist als die Schmelztemperatur des polymeren Materials.

3. Folie nach Anspruch 1, die eine Gesamtdicke von nicht mehr als etwa 100 Mikrometer hat und nicht mehr als 70 % sichtbares Licht durchläßt.

4. Folie nach Anspruch 1, bei der die Faserbändchen einen mittleren Durchmesser von etwa 8 Mikrometer oder weniger haben und als ein magnetisches soder paramagnetisches Material ausgebildet sind.

5. Folie nach Anspruch 1, bei der das polymere Material ausgewählt wird aus der Gruppe, bestehend aus Polyethylen niedriger Dichte, lineares Polyethylen niedriger Dichte, Polyethylen hoher Dichte, Ethylenmethylacrylat, Ethylenvinylacetat oder Ethylenethylacrylat.

6. Folie nach Anspruch 1, bei der die Faserbändchen in einer Menge von weniger als 15 g/m² vorliegen.

7. Folie nach Anspruch 2, bei der das polymere Trägermaterial biaxial orientiert und dimensionsstabil ist.

8. Folie nach Anspruch 7, bei der das polymere Trägermaterial ausgewählt wird aus der Gruppe, bestehend aus Polyester, Polypropylen oder Nylon.

9. Folie zur Gewährung einer statischen Abschirmung, umfassend:
eine erste Lage eines Trägermaterials, das elektrisch isolierend, flexibel, dimensionsstabil und transparent ist;
eine zweite Lage eines zweiten polymeren Meterials, das elektrisch isolierend, flexibel, transparent und thermoplastisch ist und eine Schmelztemperatur hat die höher ist als die Schmelztemperatur des ersten polymeren Materials, wobei die erste Lage mit der zweiten Lage verklebt ist;
sowie eine Vielzahl in der zweiten Lage suspendierter leitfähiger Faserbändchen, die ein weitgehend zweidimensionales, leitfähiges Netzwerk bilden, wobei die Faserbändchen ferner in einer Menge von nicht mehr als etwa 2 g/m² vorliegen und wobei die Folie mindestens 70 % sichtbares Licht durchläßt.

10. Folie nach Anspruch 9, bei der die Faserbändchen eine Schmelztemperatur oberhalb der Schmelztemperatur des zweiten polymeren Materials haben.

## Revendications

1. Un film destiné à réaliser un blindage électrostatique, comprenant:
une première couche d'une matière porteuse qui est électriquement isolante, flexible et transparente;
une deuxième couche d'une matière polymère qui est électriquement isolante, flexible, transparente et thermoplastique, ladite première couche étant attachée à ladite deuxième couche; et
une série de mèches conductrices suspendues dans la deuxième couche, formant un réseau conducteur essentiellement bidimensionnel, la température de fusion desdites mèches étant supérieure à la température de fusion de ladite matière polymère.

2. Le film selon la revendication 1, dans lequel ladite matière porteuse est polymère et sa température de fusion est supérieure à la température de fusion de ladite matière polymère.

3. Le film selon la revendication 1 dont l'épaisseur totale n'est pas supérieure à environ 100 µm et qui laisse passer au moins 70% de la lumière visible.

4. Le film selon la revendication 1 dans lequel lesdites mèches sont d'un diamètre moyen d'environ 8 µm ou moins et sont formées d'une matière magnétique ou paramagnétique.

5. Le film selon la revendication 1 dans lequel ladite matière polymère est sélectionnée dans le groupe constitué par un polyéthylène à basse densité, un polyéthylène linéaire à basse densité, un polyéthylène à haute densité, un éthylène-acrylate de méthyle, un éthylène-acétate de vinyle, ou un éthylène-acrylate d'éthyle.

6. Le film selon la revendication 1 dans lequel lesdites mèches sont présentes à une teneur inférieure à 15 g/m².

7. Le film selon la revendication 2 dans lequel ladite matière porteuse polymère est orientée biaxialement et stable dimensionnellement.

8. Le film selon la revendication 7 dans lequel ladite matière polymère porteuse est sélectionnée dans le groupe constitué par un polyester, un polypropylène ou un nylon.

9. Un film destiné à constituer un blindage électrostatique, comprenant:
une première couche d'une première matière polymère qui est électriquement isolante, flexible, dimensionnellement stable et transparente;
une deuxième couche d'une deuxième matière polymère qui est électriquement isolante, flexible, transparente et thermoplastique, et dont la température de fusion est supérieure à la température de fusion de ladite première matière polymère, ladite première couche étant attachée à ladite deuxième couche; et
une série de mèches conductrices suspendues dans ladite deuxième couche, formant un réseau conducteur essentiellement bidimensionnel, lesdites mèches étant en outre présentes à une teneur qui ne dépasse pas environ 2g/m² et le film laissant passer au moins 70% de la lumière visible.

10. Le film selon la revendication 9 dans lequel la température de fusion desdites mèches est supérieure à la température de fusion de ladite deuxième matière polymère.
